# FASCICULE DE BREVET EUROPEEN

(11) **EP 0 612 081 B1**
(45) Date de publication et mention de la délivrance du brevet: **06.09.1995**
(21) Numéro de dépôt: 94400306.0
(22) Date de dépôt: 11.02.1994
(51) Int. Cl.: H01C 1/144, G01R 15/00

(54) **Eléments résistifs de mesure de courant et modules de raccordement et de mesure**
Widerstandselemente zur Strommessung und Anschluss- und Messmodule
Resistive current measuring elements and connection- and measure modules

(30) Priorité: 15.02.1993 FR 9301671
(43) Date de publication de la demande: 24.08.1994
(73) Titulaire: SAGEM SA, F-75783 Paris Cédex 16 (FR)
(72) Inventeur: Ploix, Olivier, F-75017 Paris (FR)
(74) Mandataire: Loisel, Bertrand

(56) Documents cités:
- EP-A- 0 219 285
- EP-A- 0 391 751
- DE-A- 2 939 594
- FR-A- 2 590 028

## Description

La présente invention concerne les éléments résistifs de mesure de courant et des modules de raccordement et de mesure incorporant de tels éléments. L'invention trouve une application particulièrement importante dans les compteurs d'énergie électrique où la puissance instantanée est déterminée en faisant le produit de la tension appliquée aux bornes d'une charge et d'un signal de tension représentatif du courant qui traverse la charge.

On connaît déjà de nombreux éléments résistifs destinés à cet usage. Ils comportent de façon générale des moyens de raccordement en série avec la charge, et des moyens de prélèvement d'une différence de potentiel représentative de la chute ohmique de tension dans l'élément.

En particulier, on connaît des éléments qui sont constitués par une simple barrette munie à ses extrémités de trous de fixation sur des bornes de mise en série. La résistance électrique de la barrette est ajustée en pratiquant des encoches réduisant localement la section. Ces éléments résistifs connus ont pour inconvénient que la résistance (et donc le signal de tension fourni pour un courant donné) varie considérablement dans la plage de températures de fonctionnement, qui est typiquement de -20°C à +80°C. DE-A-29 39 594 décrit un élément résistif de mesure de courant entièrement réalisé en alliage tel que le "manganin" qui, du fait de son faible coefficient de température, est susceptible d'être moins affecté par l'inconvénient ci-dessus. Mais la réponse d'un tel élément résistif de mesure n'est pas linéaire car les lignes de courant ne sont pas parallèles dans l'ensemble de l'élément résistif, entre les points où est mesurée la différence de potentiel. Un autre risque à limiter est que l'élément de mesure puisse être endommagé en cas d'application d'un pic de tension, même s'il ne dure que quelques microsecondes.

La présente invention vise à fournir un élément résistif de mesure de courant répondant mieux que ceux antérieurement connus aux exigences de la pratique, notamment en ce qu'il écarte ou du moins atténue dans une très large mesure les inconvénients ci-dessus.

Dans ce but l'invention propose notamment un élément du type ci-dessus défini caractérisé en ce qu'il comporte un tronçon médian de section transversale constante et deux parties terminales en matériau électriquement conducteur brasées aux deux extrémités dudit tronçon médian suivant deux jonctions transversales à la direction du passage du courant, lesdites parties terminales étant munies de pattes constituant les moyens de raccordement en série, ledit tronçon médian étant en un matériau ayant une résistivité supérieure à celle du matériau des parties terminales d'au moins un ordre de grandeur et présentant une variation de résistivité en fonction de la température ne dépassant pas 25 ppm/°C, au moins entre -20°C et +80°C.

Le tronçon médian peut notamment être constitué en "manganin", qui est un alliage constitué de 4% de nickel, 10% de manganèse et 86% de cuivre en poids, dont le coefficient de variation en fonction de la température ne dépasse pas 15 ppm/°C entre 40°C et 60°C, c'est-à-dire dans le domaine de mesure rencontré le plus fréquemment. La brasure peut alors être effectuée à l'argent, qui assure une résistance de jonction faible et n'altère pas le manganin, bien qu'elle exige une température d'environ 600°C.

Les moyens de prélèvement de la différence de potentiel peuvent notamment être constitués par deux trous percés dans le tronçon médian à proximité des parties terminales ou même à travers la brasure, destinés à recevoir des picots terminaux de fils de mesure.

Du fait de la différence de résistivité entre le tronçon médian et les parties terminales, les courbures les plus importantes des lignes de courant restent confinées dans les parties terminales. Grâce à cette constitution, les lignes de courant dans le tronçon médian, c'est-à-dire dans la zone où se produit la chute de tension qui est mesurée, peuvent être rendues parallèles de façon quasi-rigoureuse. Le caractère divergent des lignes de courant dans les parties terminales est sans conséquence, puisque la différence de potentiel mesurée ne prend pas en compte la chute ohmique dans les parties terminales. Cette chute ohmique peut d'ailleurs être extrêmement faible, notamment lorsqu'on utilise du cuivre électrolytique.

Dans son second aspect, l'invention propose un module de raccordement et de mesure, comportant des moyens de connexion pour relier un fil de phase et un fil de neutre d'un réseau de distribution électrique monophasé à deux fils respectifs d'alimentation d'installations électriques situées en aval du module, caractérisé en ce que ces moyens de connexion comprennent un élément résistif de mesure de courant tel que défini ci-dessus, agencé pour être mis en contact par une de ses pattes avec le fil de phase et par son autre patte avec le fil d'alimentation correspondant.

D'autres particularités et avantages de la présente invention apparaîtront dans la description ci-après d'un exemple de réalisation préféré et non limitatif. Aux dessins annexés :
- la figure 1 est une vue en perspective d'un élément résistif selon l'invention ;
- la figure 2 est une vue en perspective d'un module de raccordement et de mesure selon l'invention ; et
- la figure 3 est un schéma illustrant un mode de connexion possible dans le module de la figure 2.

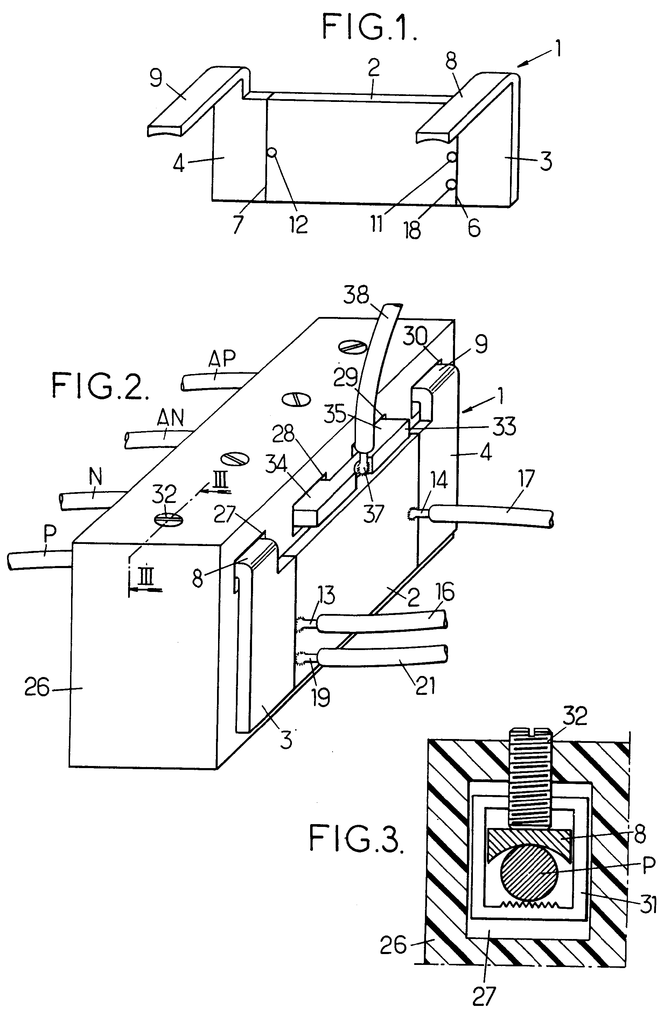

L'élément résistif 1 représenté à la figure 1 est destiné à mesurer le courant électrique circulant dans une charge. Il se compose d'un tronçon médian 2 de forme rectangulaire et de deux parties terminales conductrices 3, 4 brasées aux extrémités du tronçon médian.

Le tronçon médian 2 est réalisé en "manganin", qui est un alliage métallique composé de 4 % de nickel, 10 % de manganèse, et 86 % de cuivre, en poids, ayant une résistivité de 38,3 µΩ.cm et un coefficient de température entre 40°C et 60°C de ± 15 ppm/°C. Entre -20 et +80 °C, ce coefficient de température vaut au maximum ± 25 ppm/°C. Le courant à mesurer s'écoule dans le tronçon médian 2 entre les parties terminales 3, 4. La section transversale du tronçon médian 2 est constante de long de la direction du passage du courant.

Les parties terminales 3,4 sont réalisées en cuivre électrolytique, et soudées sur le tronçon médian 2 par de la brasure à l'argent. Une telle brasure est capable de résister à une tension de 12 kV et à un courant de 4 500 A pendant 2 millisecondes. Les brasures sont réalisées suivant deux jonctions 6, 7, qui sont transversales à la direction du passage du courant dans le tronçon médian 2.

Chaque partie terminale 3, 4 comprend une portion prolongeant le tronçon médian 2, et une patte 8, 9 s'étendant transversalement au tronçon médian 2. Les pattes 8, 9 servent à raccorder en série l'élément résistif 1 avec la charge. Chacune des pattes 8, 9 a une forme concave sur sa partie inférieure, de manière à pouvoir épouser la forme du fil à laquelle elle se raccorde pour réaliser un bon contact électrique.

Pour prélever une différence de potentiel représentative de la chute ohmique de tension dans l'élément 1, celui-ci comprend deux trous cylindriques 11, 12 percés dans le tronçon médian 2. Les trous 11, 12 sont destinés à recevoir les picots terminaux 13, 14 de deux fils de mesure 16, 17 (figure 2). La tension entre les deux fils de mesure 16, 17 est proportionnelle à l'intensité du courant traversant le tronçon médian 2, la résistance entre les deux trous 11, 12 étant typiquement de 120 µΩ à 0,6 % près, la résistance totale de l'élément résistif 1, mesurée entre les deux pattes 8, 9, étant inférieure à 170 µΩ.

Le tronçon médian 2 comporte en outre un troisième trou 18 destiné à recevoir le picot terminal 19 d'un fil de référence 21.

De préférence, les trous 11, 12, 18 ont au moins une partie située au droit des jonctions transversales 6, 7. Ainsi, comme le montre la figure 1, chaque trou 11, 12, 18 peut être ouvert à sa périphérie sur la surface d'extrémité transversale de l'élément médian 2. Cette disposition permet de fixer les picots 13, 14, 19 au moyen de la brasure d'argent utilisée pour les jonctions transversales 6, 7.

Le module de raccordement et de mesure représenté à la figure 2 comprend un bloc 26 en matière électriquement isolante dans lequel sont ménagés quatre évidements 27, 28, 29, 30. Ces évidements permettent de relier un fil de phase P et un fil de neutre N d'un réseau de distribution électrique monophasé à deux fils respectifs AP, AN d'alimentation d'installations électriques situées en aval du module. Le module comprend un élément résistif de mesure de courant 1 tel que décrit précédemment, dont le tronçon médian 2 est situé sur une face arrière du bloc 26. La patte 8 pénètre dans l'évidement 27 pour venir en contact avec le fil de phase P, au moyen d'un agencement tel que représenté à la figure 3 : un étrier 31 encadre le fil de phase P et la patte 8 qui pénètrent dans l'évidement 27 par deux faces opposées du bloc 26 ; une vis 32 accessible sur une face supérieure du bloc 26 permet de faire coulisser verticalement l'étrier 31 pour appliquer fermement l'un contre l'autre le fil de phase P et la patte 8. Par un agencement analogue, la patte 9 de l'élément 1 est mise en contact dans l'évidement 30 avec le fil d'alimentation AP.

Le module comprend en outre un cavalier conducteur 33 en forme de U ayant deux pattes parallèles 34, 35 de même forme que les pattes 8, 9, pénétrant respectivement dans les évidements 28, 29 pour venir en contact avec le fil de neutre N et le fil d'alimentation AN. Une encoche est prévue dans la base du cavalier 33 pour le soudage du picot terminal 37 d'un fil de prélèvement de tension 38.

Outre sa fonction de raccordement des installations électriques au réseau de distribution, le module représenté à la figure 2 sert à fournir des signaux de mesure utilisables pour compter l'énergie électrique consommée dans la charge constituée par les installations électriques alimentées par les fils AN et AP. La tension entre les fils de mesure 16, 17 constitue un signal de courant représentatif du courant traversant la charge. La tension entre les fils 21, 38 représente la tension appliquée à la charge, et peut être réduite par un diviseur de tension à résistances pour fournir un signal de tension. Les fils 16, 17, 21, 38 sont reliés à des circuits électroniques non représentés qui calculent l'intégrale temporelle du produit entre le signal de courant et le signal de tension pour fournir une indication de la consommation en énergie électrique dans la charge. Ces circuits sont alimentés en basse tension continue, par rapport à un potentiel de masse défini par la tension de référence prélevée par le fil 21. Cette tension continue peut être obtenue au moyen d'un circuit redresseur monté entre les fils 21 et 38.

## Revendications

1. Elément résistif de mesure de courant (1) comportant des moyens de raccordement en série avec une charge, et des moyens de prélèvement d'une différence de potentiel représentative de la chute ohmique de tension dans l'élément,
caractérisé en ce qu'il comporte un tronçon médian (2) de section transversale constante et deux parties terminales (3, 4) en matériau électriquement conducteur brasées aux deux extrémités dudit tronçon médian suivant deux jonctions (6, 7) transversales à la direction du passage du courant, lesdites parties terminales étant munies de pattes (8, 9) constituant les moyens de raccordement en série, ledit tronçon médian (2) étant en un matériau ayant une résistivité supérieure à celle du matériau des parties terminales d'au moins un ordre de grandeur et présentant une variation de résistivité en fonction de la température ne dépassant pas 25 ppm/°C, au moins entre -20°C et +80°C.

2. Elément résistif selon la revendication 1, caractérisé en ce que le tronçon médian (2) est constitué en un alliage constitué de 4 % de nickel, 10 % de manganèse et 86 % de cuivre en poids.

3. Elément résistif selon la revendication 1 ou 2, caractérisé en ce que les moyens de prélèvement de la différence de potentiel sont constitués par deux trous (11, 12) respectivement percés dans le tronçon médian (2) à proximité des deux parties terminales (3, 4), destinés à recevoir des picots terminaux (13, 14) de fils de mesure (16, 17).

4. Elément résistif selon la revendication 3, caractérisé en ce qu'il comporte un autre trou (18) percé dans le tronçon médian (2) à proximité d'une des parties terminales (3), destiné à recevoir un picot terminal (19) d'un fil de référence (21) pour fournir une référence de potentiel.

5. Elément résistif selon la revendication 3 ou 4, caractérisé en ce que lesdits trous (11, 12, 18) sont au moins partiellement situés au droit des jonctions transversales (6, 7).

6. Module de raccordement et de mesure, comportant des moyens de connexion pour relier un fil de phase (P) et un fil de neutre (N) d'un réseau de distribution électrique monophasé à deux fils respectifs (AP, AN) d'alimentation d'installations électriques situées en aval du module, caractérisé en ce que les moyens de connexion comprennent un élément résistif de mesure de courant (1) selon l'une quelconque des revendications 1 à 5 agencé pour être mis en contact par une de ses pattes (8) avec le fil de phase (P) et par son autre patte (9) avec le fil d'alimentation correspondant (AP).

7. Module de raccordement selon la revendication 6, caractérisé en ce que l'élément résistif de mesure de courant (1) comporte un trou (18) percé dans le tronçon médian (2) à proximité d'une des parties terminales (3), destiné à recevoir un fil de référence (21) pour fournir une référence de potentiel, et en ce qu'il comporte en outre un cavalier conducteur (33) ayant deux pattes (34, 35) agencées pour être mises en contact respectivement avec le fil de neutre (N) et avec le fil d'alimentation correspondant (AN), ce cavalier comportant des moyens de raccordement d'un fil de prélèvement de tension (38) fournissant, par rapport au fil de référence (21) une tension représentative de celle appliquée à la charge.

## Patentansprüche

1. Widerstandselement zur Strommessung (1) mit Anschlußmitteln zum Anschließen einer Ladung in Reihe und mit Mitteln zum Abgreifen einer Potentialdifferenz, die repräsentativ für den Ohmschen Spannungsabfall in dem Element ist,
dadurch gekennzeichnet,
daß es ein Mittelbereich (2) mit konstantem Querschnitt und zwei Endbereiche (3,4) aus elektrisch leitendem Material aufweist, welche an den beiden Enden des Mittelbereichs entlang zweier zur Richtung des Stromdurchtritts transversaler Verbindungen (6,7) angelötet sind, wobei die Endbereiche mit Laschen (8,9) versehen sind, welche die Anschlußmittel zum Anschließen in Serie bilden, wobei der Mittelbereich (2) aus einem Material besteht, dessen spezifischer Leitungswiderstand um wenigstens eine Größenordnung oberhalb desjenigen des Materials der Endbereiche ist und eine Änderung des spezifischen Leitungswiderstandes in Abhängigkeit von der Temperatur nicht über 25 ppm/°C, wenigstens zwischen -20°C und +80°C, aufweist.

2. Widerstandselement nach Anspruch 1,
dadurch gekennzeichnet,
daß der Mittelbereich (2) aus einer Verbindung besteht, die aus 4 Gew.-% Nickel, 10 Gew.-% Mangan und 86 Gew.-% Kupfer besteht.

3. Widerstandselement nach Anspruch 1 oder 2,
dadurch gekennzeichnet,
daß die Mittel zum Abgreifen der Potentialdifferenz von zwei Löchern (11,12) gebildet sind, die jeweils im Mittelbereich (2) in der Nachbarschaft der beiden Endbereiche (3,4) ausgespart sind und vorgesehen sind, um Endspitzen (13,14) von Meßdrähten (16,17) aufzunehmen.

4. Widerstandselement nach Anspruch 3,
dadurch gekennzeichnet,
daß es ein anderes Loch (18) aufweist, das im Mittelbereich (2) in der Nachbarschaft eines der beiden Endteile (3) ausgespart ist und vorgesehen ist, um eine Endspitze (19) eines Referenzdrahtes (21) zur Lieferung eines Referenzpotentials aufzunehmen.

5. Widerstandselement nach Anspruch 3 oder 4,
dadurch gekennzeichnet,
daß die Löcher (11,12,18) wenigstens bereichsweise geradlinig am Rand der Verbindungen (6,7) gelegen sind.

6. Anschluß- und Meßmodul mit Verbindungsmitteln zum Verbinden eines Phasendrahtes (P) und eines neutralen Drahtes (N) eines elektrischen einphasigen Verteilungsnetzes mit jeweils zwei Drähten (AP, AN) zur Speisung von elektrischen Einrichtungen, welche stromabwärts des Moduls gelegen sind,
dadurch gekennzeichnet,
daß die Verbindungsmittel ein Widerstandselement (1) zur Messung des Stromes gemäß irgendeinem der Ansprüche 1 bis 5 aufweist, das angeordnet ist, um mit einer der Laschen (8) mit dem Phasendraht (P) und mit seiner anderen Lasche (9) mit dem entsprechenden Speisungsdraht (AP) verbunden zu werden.

7. Anschlußmodul nach Anspruch 6,
dadurch gekennzeichnet,
daß das Widerstandselement (1) zur Messung des Stromes ein Loch (18) aufweist, welches in dem Mittelbereich (2) in der Nachbarschaft eines der Endbereiche (3) ausgespart ist und bestimmt ist, den Referenzdraht (21) zur Lieferung eines Referenzpotentials aufzunehmen, und daß es außerdem einen klammerförmigen Leiter (33) mit zwei Laschen (34,35) aufweist, die angeordnet sind, um jeweils mit dem neutralen Draht (N) und dem entsprechenden Speisungsdraht (AN) verbunden zu werden, wobei die Klammer Anschlußmittel zum Anschließen eines Drahtes (38) zum Abgreifen der Spannung aufweist, welcher im Verhältnis zum Referenzdraht (21) eine Spannung liefert, die repräsentativ für die angewandte Ladung ist.

## Claims

1. A current measuring shunt element (1) including means for connection in series with a load and means for taking a potential difference representative of the resistive voltage drop within the element,
characterized in that it comprises a middle length (2) of constant cross-section and two end portions (3,4) of electrically conductive material brazed at both ends of said middle length along two junctions (6,7) extending transversely to the current flow direction, said end portions being provided with tabs (8,9) constituting the serial connection means, said middle length (2) being made of a material of resistivity that is greater by at least one order of magnitude than the resistivity of the material constituting the end portions, and presenting variation in its resistivity as a function of temperature that does not exceed 25 ppm/°C, at least in the range -20°C to +80°C.

2. A shunt element according to claim 1, characterized in that the middle length (2) is made of an alloy constituted by 4% nickel, 10% manganese, and 86% copper, by weight.

3. A shunt element according to claim 1 or 2, characterized in that the means for taking the potential difference are constituted by two holes (11,12) formed respectively in the middle length (2) close to the two end portions (3,4) and designed to receive terminal pins (13,14) of measurement wires (16,17).

4. A shunt element according to claim 3, characterized in that it includes another hole (18) formed in the middle length (2) close to one of the end portions (3) and designed to receive a terminal pin (19) of a reference wire (21) for providing a reference potential.

5. A shunt element according to claim 3 or 4, characterized in that said holes (11,12,18) are at least partially situated at the transverse junctions (6,7).

6. A connection and measurement module including connection means for connecting a live wire (P) and a neutral wire (N) of a single phase electricity distribution network to two respective power supply wires (AP,AN) for electrical installations situated downstream from the module, characterized in that the connection means include a current measuring shunt element (1) according to any one of claims 1 to 5 and disposed to be put into contact via one of its tabs (8) with the live wire (P) and via its other tab (9) with the corresponding power supply wire (AP).

7. A connection module according to claim 6, characterized in that the current measuring shunt element (1) includes a hole (18) formed through the middle length (2) close to one of the end portions (3) and designed to receive a reference wire (21) for providing a reference potential, and in that it further includes a conductive strap (33) having two tabs (34,35) disposed so as to be put into contact respectively with the neutral wire (N) and with the corresponding power supply wire (AN), said strap including means for connection to a voltage taking wire (38) that provides a voltage relative to the reference wire (21) that is representative of the voltage applied to the load.
